# EUROPEAN PATENT APPLICATION

(11) **EP 2 259 429 A2**
(43) Date of publication of application: **08.12.2010**
(21) Application number: 10163693.4
(22) Date of filing: 24.05.2010
(51) Int. Cl.: H03K 17/96

(54) **Capacitive data input device with mechanical touch feeling**

(30) Priority: 03.06.2009 CN 200910146636
(71) Applicant: GE Medical Systems Global Technology Company LLC, Waukesha, Wisconsin 53188-1696 (US)
(72) Inventor: Zhao, Zhensong, 214028 P.R.C., Wuxi Jiangsu (CN); Jia, Zhiyuan, 214028 P.R.C., Wuxi Jiangsu (CN); Gao, Wenyou, 214028 P.R.C., Wuxi Jiangsu (CN); Liu, Lanping, 214028 P.R.C., Wuxi Jiangsu (CN)
(74) Representative: Bedford, Grant Richard

(57) **Abstract**

The present invention provides a capacitive data input device with mechanical touch feeling, e.g. a keyboard, which comprises a mechanical part (20) and a capacitive sensing part (30), wherein the mechanical part lies above the capacitive sensing part, the keys (33) in the mechanical part have a one-to-one corresponding relationship with the keypads in the capacitive sensing part, so that the respective keypads in the capacitive sensing part can be triggered by mechanically operating the keys in the mechanical part. The present invention can provide the user with a conventional mechanical touch feeling to help the user to locate quickly and accurately and avoid misoperation. Besides, since the mechanical part (20) only performs the mechanical feedback function and does not need to perform the electrical function and is removable, so that the data input device of the present invention can be cleaned or sterilized easily, and made thin and reliable.

## Description

This invention generally relates to a data input device, and more particularly to a capacitive keyboard.

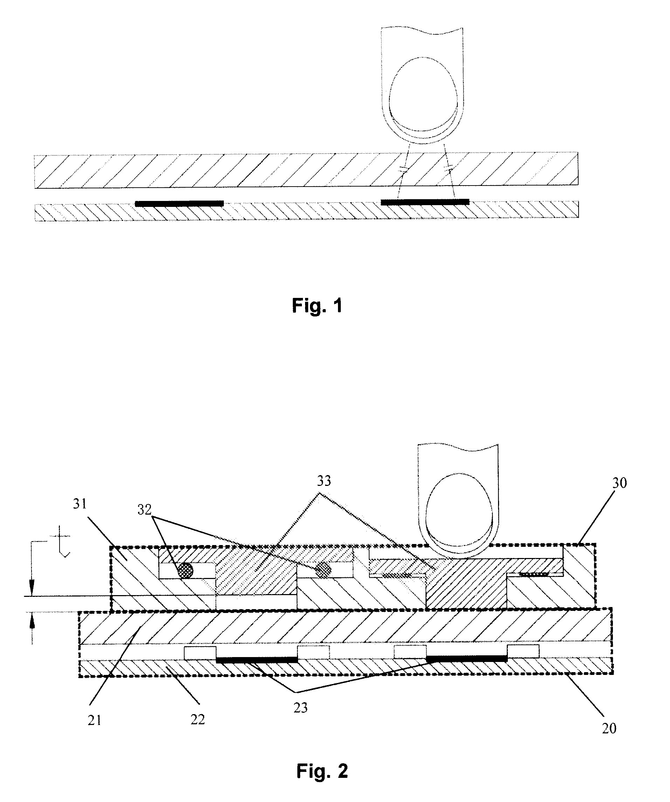

Currently, the capacitive touch sensing technology has been widely used in all kinds of electronic products, for example, as an input device (e. g. keyboard) for medical devices and household appliances like notebook computer, mobile phone, induction oven and so on. As shown in Fig. 1, in which the principle of the capacitive touch sensing button key is shown schematically, since the human body can be regarded as a body capacity, a change in the circuit capacitance is caused to occur when a finger touches the panel, and finally the resulting voltage level change indicates a corresponding key is touched. The input device adopting such a capacitive touch sensing technology does not need to have moving parts and therefore is reliable, durable, and of low power consumption. In addition, such an input device uses an integrated panel design without a gap, so that the input device is protected against adverse external operating environment conditions (for example, the fluid leaks into the device and influences the operation of the circuit board therein) and can be easily cleaned. Furthermore, this type of input device is compact in size, light in weight, and low in cost.

In spite of many advantages over the conventional mechanical technology, the capacitive touch sensing technology has some disadvantages. For example, when the capacitive touch sensing technology is applied to the keyboard input device, since the keyboard is a flat and rigid plate construction, as compared with the conventional mechanical keyboard, it does not give the finger touch feeling of pressing the button key and thus can not provide an obvious and real-time feedback. Normally, in case of using the conventional button key, the user can identify the position of the numeric keys without looking at them during the use of a mobile phone. This is also the case for the operation of the keyboard of the computer. In both cases, the user can realize a blind operation to input quickly and conveniently. However, in the case of applying the touch sensing button key, the user has to look at the keyboard to avoid pressing the wrong keys when focusing his attention on other information, which hinders the application of the capacitive touch sensing technology in many fields. To overcome this drawback, some capacitive sensing input devices use light feedback, i.e., use LED light on or off to indicate the key status, or use sound to provide a real-time feedback. Both of these feedbacks are simulated by application software and implemented together with hardware. But sometimes, since the running of the application software occupies the CPU resource, the key feedback will be delayed. On the one hand, the user may think that he has not triggered the key which he just pressed, so he will repeat the touch action. On the other hand, the application software will provide feedback for each action only after CPU is free, which may cause misoperation and malfunction. In addition, sometimes when the user does not trigger the key correctly, he couldnot get an instant feedback to correct. Moreover, some capacitive sensing input devices use the vibration method to provide feedback. This method not only consumes power, but also cannot help the user to realize "blind operation".

In the medical field, especially in the emergency room or ambulance, the medical devices are required to be easy to clean splash blood and convenient for sterilization, which promotes capacitive sensing technology to be applied. Unfortunately, the above drawbacks of the capacitive sensing keyboard may lead to inefficient operation or misoperation under an emergent condition, and may even threaten the patient's life.

According to one aspect, the present invention provides a data input device with mechanical touch feeling, which is not only well water-proof and easy to clean, but can also provide the user with a touch feeling of conventional mechanical operation, which facilitates the user to use and improves the operation efficiency.

The data input device with mechanical touch feeling of certain aspects of the present invention comprises a mechanical part and a capacitive sensing part, wherein the mechanical part lies above the capacitive sensing part. The capacitive sensing part comprises a capacitive sensing circuit board, a plurality of keypads distributed on the capacitive sensing circuit board, and a housing made of dielectric materials and covering the capacitive sensing circuit board and the keypads. The mechanical part comprises a plurality of keys and a support for bearing the plurality of keys. The keys in the mechanical part have a one-to-one corresponding relationship with the keypads in the capacitive sensing part, so that the respective keypads in the capacitive sensing part can be triggered by mechanically operating the keys in the mechanical part.

In the data input device according to an embodiment of the present invention, the keys in the mechanical part are made of conductive materials, such as conductors, insulators which are imparted with conductive property by plating process, etc.

In the data input device according to an embodiment of the present invention, the mechanical part can be removed from the capacitive sensing part, and thus the mechanical part and the capacitive sensing part can be cleaned or sterilized separately.

In the data input device according to an embodiment of the present invention, the capacitive sensing part can be used as a data input device separately, so that the embodiment is convenient for operation in a wider range of situations.

In the data input device according to an embodiment of the present invention, the capacitive sensing part comprises button keypads, the mechanical part comprises button keys corresponding to the button keypads in the capacitive sensing part, the button keys in the mechanical part are arranged on a support by an elastic member and keep a distance from the housing of the capacitive sensing part, so that when the user presses down the button key, the button key can trigger a corresponding button keypad in the capacitive sensing part.

In the data input device according to an embodiment of the present invention, the capacitive sensing part comprises slide keypads, and the mechanical part comprises slide keys corresponding to the slide keypads in the capacitive sensing part.

In the data input device according to an embodiment of the present invention, the capacitive sensing part comprises rotation keypads, the mechanical part comprises rotation keys corresponding to the rotation keypads in the capacitive sensing part, the key top of the rotation key is composed of a rotatable circularly depressed case, and a radial bar is arranged in the circularly depressed case, so that when the finger rotates the rotation key, the rotation keypad in the capacitive sensing part is triggered by the radial bar.

The data input device according to an embodiment of the present invention can be used as a keyboard for the notebook computer, mobile phone, consumer electronic device, and medical device, wherein the mechanical part is a mechanical keyboard construction that does not perform an electrical function, and the capacitive sensing part is a capacitive sensing touch keyboard construction.

Various aspects of the present invention can not only provide the user with a mechanical touch feeling to better help the user to operate quickly and accurately and avoid misoperation, but also meet the water-proof requirement to operate under adverse operating environment conditions. Besides, since the mechanical part in the data input device of various embodiments of the present invention is a pure mechanical construction, it can be cleaned or sterilized separately.

In addition, since the mechanical part in the data input device of various embodiments of the present invention can be removed from the capacitive sensing part, and the capacitive sensing part can operate as an independent data input device without the mechanical part, the data input device of the present invention can offer the user two kinds of solutions: one is a compact and simple capacitive data input device, and the other is a capacitive data input device with conventional mechanical touch feeling. In this way, various embodiments of the present invention can be applied under various conditions.

In addition, another advantage for the data input device of an embodiment of the present invention is that the data input device has a thin structure and low power consumption, etc.

Various aspects and embodiments of the present invention will now be described in connection with the accompanying drawings in which:
Fig. 1 is a diagram showing the operating principle of the capacitive keyboard in the prior art;
Fig. 2 is a schematic cross-sectional view showing a key part in the capacitive keyboard with mechanical touch feeling according to an embodiment of the present invention;
Fig. 3 is a schematic cross-sectional view showing a slide key part in the capacitive keyboard with mechanical touch feeling according to an embodiment of the present invention; and
Fig. 4 is a schematic structural view showing a rotation key part in the capacitive keyboard with mechanical touch feeling according to an embodiment of the present invention.

The invention will be described in more details hereinafter with reference to embodiments but to which the present invention is not limited.

To make the description more clear, in the capacitive data input device with mechanical touch feeling of the present invention, different sensing regions in the capacitive sensing part are referred to as "keypads", while the components in the mechanical part which correspond to individual keypads on the capacitive sensing touch keyboard are referred to as "keys".

The data input device according to an embodiment of the present invention, for example, a keyboard, comprises two primary components, i.e., a complete capacitive sensing part which can be used separately, and a removable mechanical part which is installed above the capacitive sensing part; the mechanical part has a mechanical key structure which can provide the user with a mechanical touch feeling and feedback, the mechanical key structure comprises mechanical keys corresponding to individual keypads in the capacitive sensing part and a support for bearing the mechanical keys, the keypads in the capacitive sensing part are triggered by operating the mechanical keys to perform the electrical function. In this way, it is possible to provide the user with a compact, reliable and cleanable data input device with mechanical touch feeling feedback, which meets his requirements. In the data input device according to an embodiment of the present invention, the capacitive sensing part, like the capacitive sensing touch keyboard in the prior art, comprises a capacitive sensing circuit board with a plurality of keypads, and a housing arranged on the capacitive sensing circuit board which is made of insulating materials and covers the circuit board and the keypads. The keys in the mechanical part may comprise of different kinds of keys, such as a button key (including alphanumeric button keys, function keys, and so on), rotation keys, slide keys, etc.

In the data input device according to an embodiment of the present invention, the keys in the mechanical part are made of conductive materials, and acts as the medium between the finger and the capacitive sensing part for transferring the body capacity and providing the mechanical feedback at the same time. In addition, the keys in the mechanical part can also be made of materials with a normal conductivity, such as semiconductors, poor conductors of electricity, or leakage insulating media. In addition, the keys can also be made of insulators which are imparted with conductive property by a process such as plating. The keyboard support in the mechanical keyboard part is made of insulating materials. The housing in the capacitive sensing touch keyboard is made of insulating materials.

In the data input device according to an embodiment of the present invention, marks like numerals, alphabets or text, and patterns can be printed on each keypad in the capacitive sensing part and each key in the mechanical part with well known techniques (for example, screen printing or IMD (In Mold Decoration) process), so that the keys can be located and operated conveniently or the respective keys can be illuminated by the keyboard backlighting, and in the meantime these patterns and texts can be printed on the keys in the mechanical part.

A capacitive keyboard with mechanical touch feeling, in which the data input device of the present invention is applied, is described hereinafter in connection with the drawings, wherein the capacitive keyboard with mechanical touch feeling comprises general-purpose type of keys, for example, button keys, slide keys, and rotation keys used as the alphanumeric keys and function keys.

Fig. 2 is a schematic cross-sectional view showing the button key part in the capacitive keyboard with mechanical touch feeling according to an embodiment of the present invention. As shown in Fig. 2, the capacitive keyboard with mechanical touch feeling comprises a capacitive sensing touch keyboard 20 and a mechanical keyboard 30 provided on the capacitive sensing touch keyboard 20. The capacitive sensing touch keyboard 20 comprises a circuit board 22 for the capacitive sensing touch keyboard, button keypads 23 distributed on the circuit board, and a housing 21 covering the circuit board 22 and the keypads 23 thereon. The mechanical keyboard 30 comprises a plurality of button keys 33 and a keyboard support 31 for bearing the button keys 33. For clarity, only two button keys are shown in Fig. 2, the left button key 33 is shown in a state of not being pressed down, while the right button key 33 is shown in a state of being pressed down. As can be seen from Fig. 2, the button key 33 is provided in the keyboard support by an elastic member, of which the shape may be the same as that of the conventional mechanical button key in the prior art, or other shapes convenient to be operated as desired. When the button key 33 is not pressed down, its bottom keeps a distance t from the housing 21 of the capacitive sensing touch keyboard 20. The distance t is associated with factors such as the sensing sensitivity of the capacitive sensing touch keyboard 20, which can be regulated and set as required. When the finger presses down the button key 33, the button key 33 moves downwards, and the body charges are transferred downwards through the button key 33, to sense the keypad 23 on the circuit board 22 of the capacitive sensing touch keyboard 20 which corresponds to the button key 33, wherein the button key 33 may not need to contact the housing 21, but only needs to move downwards to a position where the corresponding keypad of the capacitive sensing touch keyboard 20 can be sensed.

The button key shown in Fig. 2 can be used to fabricate the alphanumeric button keys and function keys in the capacitive keyboard with mechanical touch feeling.

For the button key 33 shown in Fig. 2, since the trigger mechanism is based on the capacity change, the acting distance of the capacitive key sensing is set to a proper distance t. When the user's finger touches the button key 33, the button key 33 will "charge" the capacity. However, due to the presence of the distance t, this capacity cannot trigger the capacitive keypad 23. Only when the button key 33 is pressed down, the body capacity is converted into an effective sensing field and triggers the capacitive keypad 23. When the user's finger leaves the button key 33, the button key 33 will return to the original position because of an internal spring component 32, such as a spring, a rubber, or an elastic support.

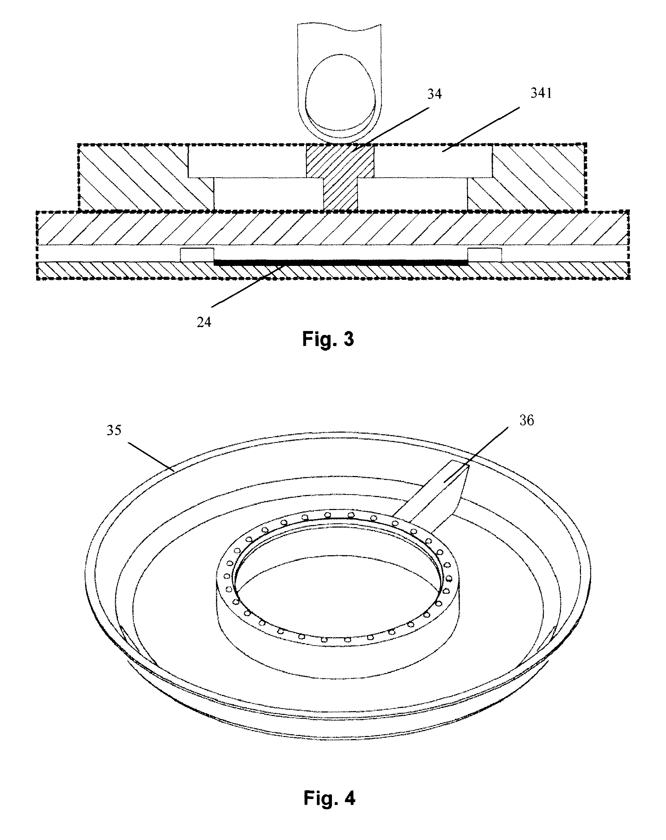

Fig. 3 is a schematic cross-sectional view showing the slide key part in the capacitive keyboard with mechanical touch feeling according to the present invention. The same components as those in Fig. 2 are not labeled in Fig. 3. As shown in Fig. 3, the slide key 34 lies in a keyboard support of the mechanical keyboard device 30 of the capacitive keyboard with mechanical touch feeling according to the present invention, and can slide in the sliding space 341. The end of the slide key 34 can contact the housing 21 of the capacitive sensing touch keyboard 20, and can also lie within the sensing distance that can sense the slide keypad 24 in the capacitive sensing touch keyboard 20 without contacting the housing. The shape of the slide key may be the same as that of the conventional mechanical slide key in the prior art, or can be other shapes convenient to be operated as desired.

For the slide key 34, since the trigger mechanism is based on the capacity sliding change, there is no need for the distance t. When the user's finger touches the slide key 34, the slide key will 'charge' the capacity. But since there is no sliding change, the capacitive sensing slide keypad 24 will not be triggered. Only when the user moves the slide key 34, the capacitive sensing slide keypad 24 is triggered and functions.

Fig. 4 is a schematic structural view showing the rotation key in the capacitive keyboard with mechanical touch feeling according to an embodiment of the present invention. As shown in Fig. 4, the rotation key in the mechanical keyboard device comprises a rotatable circularly depressed key top 35 which is made of a conductive material, and a radial bar 36 is arranged in the circular depression of the key top.

For the rotation key, the operation principle is the same as that of the slide key 34. When the user rotates the rotation key, the capacity will converge to the radial bar 36, and the body capacity is transferred to the corresponding sensing region of the capacitive sensing keyboard, so that the capacitive sensing rotation keypad can judge the exact position change, and thus is triggered and functions.

In addition, in the data input device of various embodiments of the present invention, a capacitive sensing touch panel can be used to realize the function of a trackball.

Since the mechanical key in the keyboard of various embodiments of the present invention needs to perform only the mechanical feedback function and does not need to perform the electrical function, the whole keyboard can be designed as a pure mechanical keyboard, which is not only thin but also reliable. The mechanical keyboard part can be removed from the medical device, so that it can be cleaned sterilized with a liquid separately. In addition, since the mechanical keyboard part can be removed, the medical device can only use the capacitive sensing touch medical keyboard in some special application conditions, such as military use, operating room, etc.

In addition, the design of all these mechanical keys in aspects of the present invention can reference the current mechanical key top design technology and backlighting technology and so on, in order that they are of the best finger touch feeling, thinner, and more reliable.

Moreover, since various aspects of the present invention can help the user to operate quickly and accurately, it can not only be applied to the medical device such as a portable ultrasound imaging diagnostic device, but also to other fields such as consumer electronic device, notebook computer, mobile phone and so on.

While the present invention has been described with reference to specific embodiments thereof, it should be noted that numerous improvements, modifications and variations may be made by those having ordinary skills in the art without departing from the spirit of the present invention, and such improvements, modifications and variations should be considered to fall within the protection scope of the application.

## Claims

1. A data input device comprising a mechanical part (30) and a capacitive sensing part (20), wherein the mechanical part lies above the capacitive sensing part, the capacitive sensing part comprises a capacitive sensing circuit board (22), a plurality of keypads (23) distributed on the capacitive sensing circuit board, and a housing (21) made of dielectric materials and covering the capacitive sensing circuit board and the keypads, the mechanical part comprises a plurality of keys (33) and a support for bearing the plurality of keys, the keys in the mechanical part have a one-to-one corresponding relationship with the keypads in the capacitive sensing part, so that the respective keypads in the capacitive sensing part can be triggered by mechanically operating the keys in the mechanical part.

2. The data input device of claim 1, wherein the keys (33) in the mechanical part (30) are made of conductive materials.

3. The data input device of any preceding claim, wherein the mechanical part (30) can be removed from the capacitive sensing part (20).

4. The data input device of any preceding claim, wherein the capacitive sensing part (30) can be used as a data input device separately.

5. The data input device of any preceding claim, wherein the capacitive sensing part (30) comprises button keypads, the mechanical part comprises button keys (33) corresponding to the button keypads in the capacitive sensing part, the button keys in the mechanical part (20) are arranged on the support by an elastic member and keep a distance from the housing of the capacitive sensing part, so that when the user presses down the button key, the button key can trigger the corresponding button keypad in the capacitive sensing part.

6. The data input device of any preceding claim, wherein the capacitive sensing part (30) comprises slide keypads, and the mechanical part (20) comprises slide keys corresponding to the slide keypads in the capacitive sensing part.

7. The data input device of any preceding claim, wherein the capacitive sensing part (30) comprises rotation keypads, the mechanical part (20) comprises rotation keys corresponding to the rotation keypads in the capacitive sensing part, the key top of the rotation key is composed of a rotatable circularly depressed case, and a radial bar is arranged in the circularly depressed case, so that when the finger rotates the rotation key, the rotation keypad in the capacitive sensing part is triggered by the radial bar.

8. The data input device of any one of claim 1-7, used as a keyboard for a notebook computer, a mobile phone, a consumer electronic device, or a medical device.
